# EUROPÄISCHE PATENTSCHRIFT

(11) **EP 2 225 540 B1**
(45) Veröffentlichungstag und Bekanntmachung des Hinweises auf die Patenterteilung: **24.10.2018**
(21) Anmeldenummer: 08861031.6
(22) Anmeldetag: 04.12.2008
(51) Int. Cl.: G01F 23/38, H01C 10/32, H01H 36/02, H01H 1/023, H05K 1/03, H05K 1/09, H05K 3/24, B60K 15/03, G01F 23/36, G01D 5/165, H05K 3/40

(54) **TANKGEBERPLATINE FÜR EINEN FÜLLSTANDSGBER EINES FAHRZEUGTANKS**
TANK SENSOR CIRCUIT BOARD FOR A FILL LEVEL SENSOR IN A VEHICLE TANK
CARTE DE CIRCUITS IMPRIMÉS POUR INDICATEUR DE NIVEAU DE REMPLISSAGE D'UN RÉSERVOIR DE VÉHICULE

(30) Priorität: 19.12.2007 DE 102007061316
(43) Veröffentlichungstag der Anmeldung: 08.09.2010
(73) Patentinhaber: Continental Automotive GmbH, 30165 Hannover (DE)
(72) Erfinder: MATTMANN, Erich, 55262 Heidesheim (DE)
(86) Internationale Anmeldenummer: PCT/EP2008/066784
(87) Internationale Veröffentlichungsnummer: WO 2009/077342

(56) Entgegenhaltungen:
- DE-A1- 19 701 246
- US-A1- 2004 196 137
- US-B1- 6 518 873

## Beschreibung

Die Erfindung bezieht sich auf eine Tankgeberplatine für einen Füllstandsgeber eines Fahrzeugtanks, mit einem Trägerelement, auf dem in Dickschichttechnik Kontaktflächen aufgebracht sind, die Silber enthalten.

Bei derartigen Tankgeberplatinen ist es bekannt die Kontaktflächen aus Silber-Palladium oder aber auch aus Silber-Palladium-Gold herzustellen. Diese Werkstoffe sollen für eine Kraftstoff- und Abriebbeständigkeit der Kontaktflächen sorgen.

Diese in einer Schichtdicke von etwa 15 µm in Dickschichttechnik aufgebrachten Kontaktflächen sind aufgrund der Edelmetalle Gold und Palladium sehr
US 6 518 873 B1 offenbart eine solche Tankgeberplatine.

Aufgabe der Erfindung ist es daher eine Tankgeberplatine der eingangs genannten Art zu schaffen, deren Kontaktflächen sowohl kostengünstig als auch kraftstoff- und abriebbeständig sind.

Diese Aufgabe wird erfindungsgemäß dadurch gelöst, dass die Kontaktflächen aus einer auf eine erste Oberfläche des Trägerelements aufgebrachten Silberschicht oder Silber enthaltenden Schicht und einer die Silberschicht oder Silber enthaltenden Schicht ganz oder teilweise überdeckenden Nickel, Palladium und Gold enthaltenden Deckschicht besteht.

Für gute Leiteigenschaften sorgt dabei die Silberschicht oder Silber enthaltende Schicht, die aber nicht kraftstoff- und abriebfest ist.

Da eine Kraftstoff- und Abriebfestigkeit nur an der freien Oberfläche der Kontaktflächen erforderlich ist, ist es ausreichend die Silberschicht oder Silber enthaltende Schicht mit der diese Eigenschaften aufweisenden Deckschicht zu versehen.

Dabei sorgt das Palladium, das in das Gold diffundiert, für ein festes und damit verschleißarmes Gefüge der Deckschicht, während das Nickel zu einer guten Lötbarkeit der Kontaktflächen führt.

Dies führt zu einem Kostenvorteil in der Größenordnung von 50 %.

Erfindungsgemäß besteht die Deckschicht aus separaten Schichten aus Nickel, Palladium und Gold, wobei die Silberschicht oder Silber enthaltende Schicht von einer ersten Palladiumschicht, die erste Palladiumschicht von einer Nickelschicht, und die Nickelschicht von einer Goldschicht bedeckt ist.

Das Gold als oberste Schicht sorgt für einen guten Kontakt zu einem auf die Kontaktflächen auflegbaren Kontaktelement.

Zur weiteren Erhöhung der Verschleißfestigkeit der Goldschicht ist die Nickelschicht von einer zweiten Palladiumschicht, die Goldschicht trägt, bedeckt.

Da die Dicke der Silberschicht oder Silber enthaltende Schicht ein Mehrfaches der Dicke der Deckschicht betragen kann, wird durch die geringe Dicke der Deckschicht nur wenig von dessen teurem Material benötigt.

Die Dicke der Silberschicht oder Silber enthaltenden Schicht kann das 20- bis 40-fache der Dicke der Deckschicht betragen, wobei sie vorzugsweise das 25- bis 35-fache, insbesondere das 30-fache der Dicke der Deckschicht beträgt.

Die Silberschicht oder Silber enthaltende Schicht kann eine Dicke von 10 µm bis 200 µm, insbesondere von 15 µm, die erste Palladiumschicht eine Dicke von 0,001 µm bis 0,02 µm, insbesondere von 0,01 µm, die Nickelschicht eine Dicke von 3 µm bis 7 µm, insbesondere von 5 µm, die zweite Palladiumschicht eine Dicke von 0,1 µm bis 0,7 µm, insbesondere von 0,5 µm und die Goldschicht eine Dicke von 0,05 µm bis 0,14 µm, insbesondere von 0,12 µm aufweisen.

Zur Kraftstoffbeständigkeit besteht vorzugsweise das Trägerelement aus Keramik.

Zur Ausnutzung der vorhandenen Flächen und damit zur Reduzierung des erforderlichen Bauraums können zweite Kontaktflächen auf der zweiten Oberfläche des Trägerelements aufgebracht sein, wobei erste und zweite Kontaktflächen elektrisch leitend miteinander verbunden sein können.

In einer einfachen Ausbildung können dabei erste und zweite Kontaktflächen mittels Durchkontaktierungen im Trägerelement elektrisch leitend miteinander verbunden sein, die aus das Trägerelement durchragenden, gasdicht verschlossenen und an ihren Wänden metallisierten oder vollständig mit einer Metallfüllung gefüllten Durchgangsöffnungen bestehen.

Der Herstellungsprozess wird dadurch vereinfacht, wenn die Metallisierung oder die Metallfüllung aus demselben Werkstoff besteht wie die Kontaktflächen.

Um die nicht zu beschichtenden Bereiche der Kontaktflächen bei dem Aufbringen der Deckschicht von der Deckschicht freizuhalten, können die von der Deckschicht unbedeckten Bereiche der Silberschicht oder Silber enthaltenden Schicht von einer Schutzschicht bedeckt sein.

In einfacher Weise ist dabei die Schutzschicht eine Glasschicht.

Um ein Widerstandsnetzwerk zu erzeugen, können auf dem Trägerelement den Kontaktflächen benachbart ein oder mehrere Widerstandsschichten in Dickschichttechnik aufgebracht sein, die zum Freihalten bei dem Aufbringen der Deckschicht von der Schutzschicht bedeckt sein können.

Eine Kontaktierung der Kontaktflächen kann dadurch erfolgen, dass ein in Abhängigkeit vom Füllstand des Fahrzeugtanks schwenkbares Schleiferelement auf den eine Schleiferbahn bildenden Deckschichten der Kontaktflächen aufliegend bewegbar ist, so dass ein Potentiometer gebildet wird.

In einer anderen Ausbildung können eines von mehreren eine Kontaktbahn bildenden Kontaktelementen in Abhängigkeit vom Füllstand des Fahrzeugtanks zur Anlage an Deckschichten der Kontaktflächen auslenkbar sein.

Bestehen dabei das Schleiferelement oder die Kontaktelemente zumindest teilweise aus Gold, so führt dies zu einer guten und sicheren Kontaktierung.

Ausführungsbeispiele der Erfindung sind in der Zeichnung dargestellt und werden im Folgenden näher beschrieben. Es zeigen
- Figur 1: einen Querschnitt einer Tankgeberplatine,
- Figur 2: eine vergrößerte Prinzipdarstellung zweier auf ein Trägerelement aufgebrachten Kontaktflächen der Tankgeberplatine nach Figur 1,
- Figur 3: eine Explosionsdarstellung eines Tankgebersensors,
- Figur 4: einen Schnitt entlang der Linie III - III des Tankgebersensors in Figur 3.

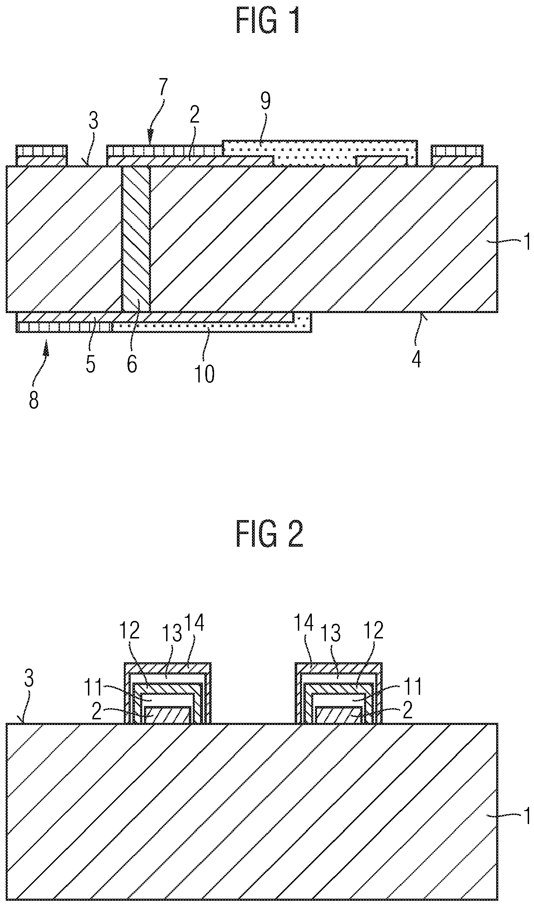

Die in den Figuren 1 und 2 dargestellte Tankgeberplatine weist ein plattenartiges Trägerelement 1 aus Keramik auf, auf dessen erster Oberfläche 3 eine Kontaktfläche 18 aufgebracht ist, die eine erste Silberschicht 2 mit einer Dicke von 15 µm aufweist.

In einem freigelassenen Bereich der Silberschicht 2 ist eine Widerstandsschicht 15 auf die erste Oberfläche 3 des Trägerelements 1 aufgebracht.

Auf einer zur ersten Oberfläche 3 parallelen zweiten Oberfläche 4 des Trägerelements 1 ist etwa gegenüberliegend der ersten Silberschicht 2 eine zweite Silberschicht 5 mit gleicher Dicke aufgebracht.

Zwischen der ersten und der zweiten Silberschicht 2 und 5 ist in dem Trägerelement 1 eine Durchgangsöffnung 6 angeordnet, deren Wände mit Silber metallisiert sind, so dass eine Durchkontaktierung zwischen der ersten und der zweiten Silberschicht 2 und 5 gebildet ist.

Die Enden der Durchgangsöffnung 6 sind von der ersten und der zweiten Silberschicht 2 und 5 gasdicht verschlossen.

Nach dem Aufbringen der Silberschichten 2 und 5 auf das Trägerelement 1 wurden die von später auf die Silberschichten 2 und 5 aufzubringenden Deckschichten 7 und 8 unbedeckten Bereiche sowie die Widerstandsschicht 15 von Glasschichten 9 und 10 bedeckt, indem Glasfritte aufgebracht und aufgeschmolzen wird.

Diese Glasschichten 9 und 10 verhindern bei dem anschließenden Aufbringen der Deckschichten 7 und 8 auf die Silberschichten 2 und 5, das die nicht zu bedeckenden Bereiche frei von Deckschichten 7 und 8 verbleiben.

Wie in Figur 2 zu erkennen ist, bestehen die Deckschichten 7 und 8 aus zunächst auf die Silberschichten 2 und 5 aufgebrachten ersten Paladiumschichten 11 mit einer Dicke von 0,01 µm.

Darauf werden Nickelschichten 12 mit einer Dicke von 5 µm, darauf wiederum zweite Palladiumschichten 13 mit einer Dicke von 0,5 µm und zuletzt darauf wieder Goldschichten 14 mit einer Dicke von 0,12 µm in Dickschichttechnik aufgebracht.

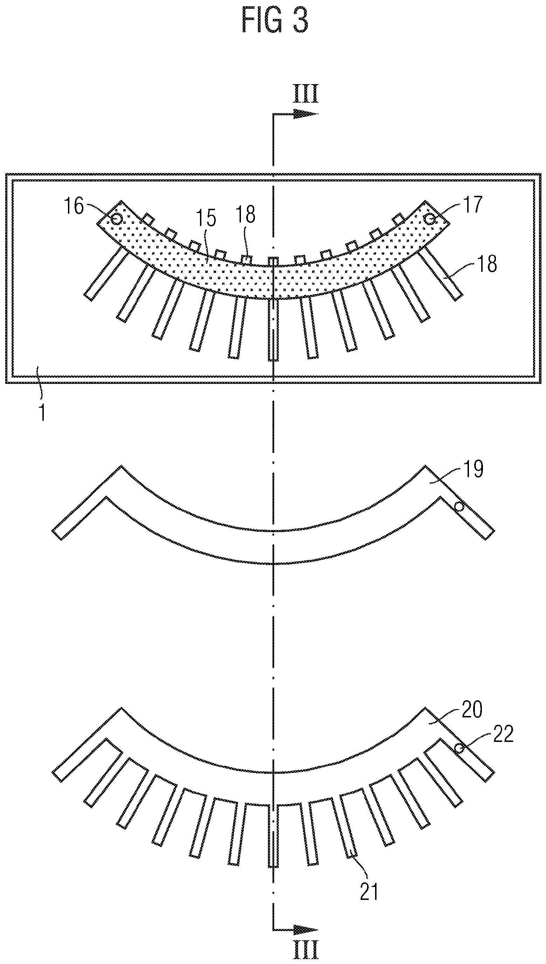

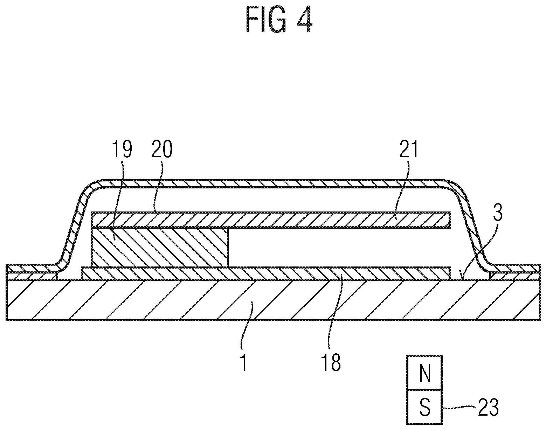

Der in den Figuren 3 und 4 dargestellte magnetische Positionssensor ist in Form eines bogenförmigen Potentiometers dargestellt.

Dabei trägt das Trägerelement 1 ein Widerstandsnetzwerk in Form einer bahnförmigen Widerstandsschicht 15, welche sich zwischen elektrischen Anschlüssen 16 und 17 erstreckt.

Von der Widerstandsschicht 15 etwa radial ausgehend und mit dieser elektrisch leitend verbunden sind auf dem Trägerelement 1 in einem Abstand zueinander mehrere Kontaktflächen 18 angeordnet.

Auf der Widerstandsschicht 15 mit dieser etwa deckungsgleich ist eine Abstandshalterschicht 19 angeordnet, auf welcher eine weichmagnetische einstückige und kammartige Biegebalkenstruktur 20 angeordnet ist.

Die Biegebalkenstruktur 20 besteht aus einseitig im Bereich der Widerstandsschicht 15 gestützten, frei beweglichen Biegebalken 21, die mit Gold beschichtete Kontaktelemente bilden.

Die Abstandshalterschicht 19 hält die freibeweglichen Enden der Biegebalkenstruktur 20 in einem definierten Abstand zu den Kontaktflächen 18, wobei die freibeweglichen Enden der Biegebalken 21 überdeckend zu den Kontaktflächen 18 angeordnet sind.

Die elektrisch leitfähige Biegebalkenstruktur 20 steht mit einem außenliegenden elektrischen Anschluss 22 in Verbindung.

Die Widerstandsschicht 15 ist über die Anschlüsse 16 und 17 elektrisch mit Masse und einer Betriebsspannung verbunden.

Eine Signalspannung des Positionssensors ist über den elektrischen Anschluss 22 abgreifbar.

Die Signalspannung ist in einem Bereich von 0 V bis zur Betriebsspannung variierbar und stellt die Position eines Permanentmagneten 23 dar, der z. B. in Abhängigkeit eines Schwimmers eines Füllstandsgebers im Tank eines Fahrzeugs bewegbar ist.

Der Permanentmagnet 23 ist auf der die Kontaktflächen 18 tragenden Seite abgewandeten Seite des Trägerelements 1 entlang der Biegebalkenstruktur 20 bewegbar und zieht jeweils den Biegebalken 21, der ihm gegenüberliegt, auf eine Kontaktfläche 18.

Dadurch wird entsprechend der Position des Permanentmagneten 23 eine elektrische Verbindung zu der entsprechenden Position der Widerstandsschicht 15 erzeugt und eine dieser Position entsprechende Signalspannung abgegriffen und einer nicht dargestellten Anzeigeeinheit zugeführt.

Die auf dem Trägerelement 1 angeordneten Kontaktflächen, die Widerstandsschicht und die Abstandshalterschicht sind von einem auf dem Trägerelement 1 angeordneten Gehäuse abgedeckt.

## Patentansprüche

1. Tankgeberplatine für einen Füllstandsgeber eines Fahrzeugtanks, mit einem Trägerelement, auf dem in Dickschichttechnik Kontaktflächen aufgebracht sind, die Silber enthalten, wobei die Kontaktflächen (18) aus einer auf eine erste Oberfläche (3) des Trägerelements (1) aufgebrachten Silberschicht (2) oder Silber enthaltenden Schicht und einer die Silberschicht (2, 5) oder Silber enthaltenden Schicht ganz oder teilweise überdeckenden Nickel, Palladium und Gold enthaltenden Deckschicht (7, 8) bestehen und die Deckschicht aus separaten Schichten aus Nickel, Palladium und Gold besteht, **dadurch gekennzeichnet, dass** die Silberschicht (2, 5) oder Silber enthaltende Schicht von einer ersten Palladiumschicht (11), die erste Palladiumschicht (11) von einer Nickelschicht (12) und die Nickelschicht (12) von einer Goldschicht (14) bedeckt ist, wobei die Nickelschicht (12) von einer zweiten Palladiumschicht (13) bedeckt ist, die die Goldschicht (14) trägt.

2. Tankgeberplatine nach Anspruch 1, **dadurch gekennzeichnet, dass** die Dicke der Silberschicht (2, 5) oder Silber enthaltende Schicht ein Mehrfaches der Dicke der Deckschicht (7, 8) beträgt.

3. Tankgeberplatine nach Anspruch 2, **dadurch gekennzeichnet, dass** die Dicke der Silberschicht (2, 5) oder Silber enthaltende Schicht das 20-bis 40-fache der Dicke der Deckschicht (7, 8) beträgt.

4. Tankgeberplatine nach Anspruch 2, **dadurch gekennzeichnet, dass** die Dicke der Silberschicht (2, 5) oder Silber enthaltende Schicht das 25-bis 35-fache, insbesondere das 30-fache der Dicke der Deckschicht (7, 8) beträgt.

5. Tankgeberplatine nach einem der vorhergehenden Ansprüche, **dadurch gekennzeichnet, dass** die Silberschicht (2, 5) oder Silber enthaltende Schicht eine Dicke von 10 µm bis 200 µm, insbesondere von 15 µm aufweist.

6. Tankgeberplatine nach einem der vorhergehenden Ansprüche, **dadurch gekennzeichnet, dass** die erste Palladiumschicht (11) eine Dicke von 0,001 µm bis 0,02 µm, insbesondere von 0,01 µm aufweist.

7. Tankgeberplatine nach einem der vorhergehenden Ansprüche, **dadurch gekennzeichnet, dass** die Nickelschicht (12) eine Dicke von 3 µm bis 7 µm, insbesondere von 5 µm aufweist.

8. Tankgeberplatine nach einem der vorhergehenden Ansprüche, **dadurch gekennzeichnet, dass** die zweite Palladiumschicht (13) eine Dicke von 0,1 µm bis 0,7 µm, insbesondere von 0,5 µm aufweist.

9. Tankgeberplatine nach einem der vorhergehenden Ansprüche,
**dadurch gekennzeichnet, dass** die Goldschicht (14) eine Dicke von 0,05 µm bis 0,14 µm, insbesondere von 0,12 µm aufweist.

10. Tankgeberplatine nach einem der vorhergehenden Ansprüche, **dadurch gekennzeichnet, dass** das Trägerelement (1) aus Keramik besteht.

11. Tankgeberplatine nach einem der vorhergehenden Ansprüche, **dadurch gekennzeichnet, dass** zweite Kontaktflächen (24) auf der zweiten Oberfläche (4) des Trägerelements (1) aufgebracht sind.

12. Tankgeberplatine nach Anspruch 11, **dadurch gekennzeichnet, dass** erste und zweite Kontaktflächen (18, 24) elektrisch leitend miteinander verbunden sind.

13. Tankgeberplatine nach Anspruch 12, **dadurch gekennzeichnet, dass** erste und zweite Kontaktflächen (18, 24) mittels Durchkontaktierungen im Trägerelement (1) elektrisch leitend miteinander verbunden sind.

14. Tankgeberplatine nach Anspruch 13, **dadurch gekennzeichnet, dass** die Durchkontaktierungen aus das Trägerelement (1) durchragenden, gasdicht verschlossenen und an ihren Wänden metallisierten oder vollständig mit einer Metallfüllung gefüllten Durchgangsöffnungen (6) bestehen.

15. Tankgeberplatine nach Anspruch 14, **dadurch gekennzeichnet, dass** die Metallisierung oder die Metallfüllung aus demselben Werkstoff besteht wie die Kontaktflächen (18, 24).

16. Tankgeberplatine nach einem der vorhergehenden Ansprüche, **dadurch gekennzeichnet, dass** die von der Deckschicht (7, 8) unbedeckten Bereiche der Silberschicht (2, 5) oder Silber enthaltenden Schicht von einer Schutzschicht bedeckt sind.

17. Tankgeberplatine nach Anspruch 16, **dadurch gekennzeichnet, dass** die Schutzschicht eine Glasschicht (9, 10) ist.

18. Tankgeberplatine nach einem der vorhergehenden Ansprüche, **dadurch gekennzeichnet, dass** auf dem Trägerelement (1) den Kontaktflächen (18) benachbart ein oder mehrere Widerstandsschichten (15) in Dickschichttechnik aufgebracht sind.

19. Tankgeberplatine nach Anspruch 18, **dadurch gekennzeichnet, dass** die Widerstandsschichten (15) von der Schutzschicht bedeckt sind.

20. Tankgeberplatine nach einem der vorhergehenden Ansprüche, **dadurch gekennzeichnet, dass** ein in Abhängigkeit vom Füllstand des Fahrzeugtanks schwenkbares Schleiferelement auf den eine Schleiferbahn bildenden Deckschichten der Kontaktflächen aufliegend bewegbar ist.

21. Tankgeberplatine nach einem der Ansprüche 1 bis 20, **dadurch gekennzeichnet, dass** eines von mehreren eine Kontaktbahn bildenden Kontaktelementen in Abhängigkeit vom Füllstand des Fahrzeugtanks zur Anlage an Deckschichten (7) der Kontaktflächen (18) auslenkbar sind.

22. Tankgeberplatine nach einem der Ansprüche 20 und 21, **dadurch gekennzeichnet, dass** das Schleiferelement oder die Kontaktelemente zumindest teilweise aus Gold bestehen.

## Claims

1. Tank sensor circuit board for a fill level sensor in a vehicle tank, having a carrier element on which contact faces containing silver are applied using thick film technology, wherein the contact faces (18) are composed of a silver layer (2) which is applied to a first surface (3) of the carrier element (1), or a silver-containing layer, and of a top layer (7, 8) which entirely or partially covers the silver layer or silver-containing layer and contains nickel, palladium and gold, and the top layer is composed of separate layers made of nickel, palladium and gold **characterized in that** the silver layer (2, 5) or silver-containing layer is covered by a first palladium layer (11), the first palladium layer (11) is covered by a nickel layer (12), and the nickel layer (12) is covered by a gold layer (14), wherein the nickel layer (12) is covered by a second palladium layer (13) which supports the gold layer (14).

2. Tank sensor circuit board according to Claim 1, **characterized in that** the thickness of the silver layer (2, 5) or silver-containing layer is a multiple of the thickness of the top layer (7, 8).

3. Tank sensor circuit board according to Claim 2, **characterized in that** the thickness of the silver layer (2, 5) or silver-containing layer is 20 to 40 times the thickness of the top layer (7, 8).

4. Tank sensor circuit board according to Claim 2, **characterized in that** the thickness of the silver layer (2, 5) or silver-containing layer is 25 to 35 times, in particular 30 times, the thickness of the top layer (7, 8).

5. Tank sensor circuit board according to one of the preceding claims, **characterized in that** the silver layer (2, 5) or silver-containing layer has a thickness of 10 µm to 200 µm, in particular of 15 µm.

6. Tank sensor circuit board according to one of the preceding claims, **characterized in that** the first palladium layer (11) has a thickness of 0.001 µm to 0.02 µm, in particular of 0.01 µm.

7. Tank sensor circuit board according to one of the preceding claims, **characterized in that** the nickel layer (12) has a thickness of 3 µm to 7 µm, in particular of 5 µm.

8. Tank sensor circuit board according to one of the preceding claims, **characterized in that** the second palladium layer (13) has a thickness of 0.1 µm to 0.7 µm, in particular of 0.5 µm.

9. Tank sensor circuit board according to one of the preceding claims, **characterized in that** the gold layer (14) has a thickness of 0.05 µm to 0.14 µm, in particular of 0.12 µm.

10. Tank sensor circuit board according to one of the preceding claims, **characterized in that** the carrier element (1) is composed of ceramic.

11. The tank sensor circuit board according to one of the preceding claims, **characterized in that** second contact faces (24) are applied to the second surface (4) of the carrier element (1).

12. Tank sensor circuit board according to Claim 11, **characterized in that** the first and the second contact faces (18, 24) are connected to one another in an electrically conductive fashion.

13. Tank sensor circuit board according to Claim 12, **characterized in that** the first and second contact faces (18, 24) are connected to one another in an electrically conductive fashion by means of vias in the carrier element (1).

14. Tank sensor circuit board according to Claim 13, **characterized in that** the vias are composed of through-openings (6) which project out of the carrier element (1), are closed off in a gastight fashion and are metallized on their walls or completely filled with a metal filling.

15. Tank sensor circuit board according to Claim 14, **characterized in that** the metallization or the metal filling is composed of the same material as the contact faces (18, 24).

16. Tank sensor circuit board according to one of the preceding claims, **characterized in that** the regions of the silver layer (2, 5) or silver-containing layer which are not covered by the top layer (7, 8) are covered by a protective layer.

17. Tank sensor circuit board according to Claim 16, **characterized in that** the protective layer is a glass layer (9, 10).

18. Tank sensor circuit board according to one of the preceding claims, **characterized in that** one or more resistance layers (15) are applied to the carrier element (1) adjacent to the contact faces (18) using thick film technology.

19. Tank sensor circuit board according to Claim 18, **characterized in that** the resistance layers (15) are covered by the protective layer.

20. Tank sensor circuit board according to one of the preceding claims, **characterized in that** a slide element, which can be pivoted as a function of the filling level of the vehicle tank, can move while resting on the top layers, forming a slider path, of the contact faces.

21. Tank sensor circuit board according to one of Claims 1 to 20, **characterized in that** one of several contact elements which form a contact track are deflectable as a function of the fill level of the vehicle tank in order to bear on top layers (7) of the contact faces (18).

22. Tank sensor circuit board according to one of Claims 20 and 21, **characterized in that** the slide element or the contact elements are composed at least partially of gold.

## Revendications

1. Carte de circuits imprimés pour un indicateur de niveau de remplissage d'un réservoir de véhicule, avec un élément de support, sur lequel des faces de contact qui contiennent de l'argent sont déposées par la technique des couches épaisses, dans laquelle les faces de contact (18) se composent d'une couche d'argent (2) ou d'une couche contenant de l'argent déposée sur une première surface (3) de l'élément de support (1) et d'une couche de recouvrement (7, 8) contenant du nickel, du palladium et de l'or recouvrant entièrement ou partiellement la couche d'argent (2, 5) ou la couche contenant de l'argent et la couche de recouvrement se compose de couches séparées de nickel, de palladium et d'or, **caractérisée en ce que** la couche d'argent (2, 5) ou la couche contenant de l'argent est recouverte par une première couche de palladium (11), la première couche de palladium (11) est recouverte par une couche de nickel (12) et la couche de nickel (12) est recouverte par une couche d'or (14), dans laquelle la couche de nickel (12) est recouverte par une deuxième couche de palladium (13), qui porte la couche d'or (14).

2. Carte de circuits imprimés selon la revendication 1, **caractérisée en ce que** l'épaisseur de la couche d'argent (2, 5) ou de la couche contenant de l'argent vaut un multiple de l'épaisseur de la couche de recouvrement (7, 8).

3. Carte de circuits imprimés selon la revendication 2, **caractérisée en ce que** l'épaisseur de la couche d'argent (2, 5) ou de la couche contenant de l'argent vaut 20 fois à 40 fois l'épaisseur de la couche de recouvrement (7, 8).

4. Carte de circuits imprimés selon la revendication 2, **caractérisée en ce que** l'épaisseur de la couche d'argent (2, 5) ou de la couche contenant de l'argent vaut 25 fois à 35 fois, en particulier 30 fois, l'épaisseur de la couche de recouvrement (7, 8).

5. Carte de circuits imprimés selon l'une quelconque des revendications précédentes, **caractérisée en ce que** la couche d'argent (2, 5) ou la couche contenant de l'argent présente une épaisseur de 10 µm à 200 µm, en particulier de 15 µm.

6. Carte de circuits imprimés selon l'une quelconque des revendications précédentes, **caractérisée en ce que** la première couche de palladium (11) présente une épaisseur de 0,001 µm à 0,02 µm, en particulier de 0,01 µm.

7. Carte de circuits imprimés selon l'une quelconque des revendications précédentes, **caractérisée en ce que** la couche de nickel (12) présente une épaisseur de 3 µm à 7 µm, en particulier de 5 µm.

8. Carte de circuits imprimés selon l'une quelconque des revendications précédentes, **caractérisée en ce que** la deuxième couche de palladium (13) présente une épaisseur de 0,1 µm à 0,7 µm, en particulier de 0,5 µm.

9. Carte de circuits imprimés selon l'une quelconque des revendications précédentes, **caractérisée en ce que** la couche d'or (14) présente une épaisseur de 0,05 µm à 0,14 µm, en particulier de 0,12 µm.

10. Carte de circuits imprimés selon l'une quelconque des revendications précédentes, **caractérisée en ce que** l'élément de support (1) est constitué de céramique.

11. Carte de circuits imprimés selon l'une quelconque des revendications précédentes, **caractérisée en ce que** des deuxièmes faces de contact (24) sont déposées sur la deuxième surface (4) de l'élément de support (1).

12. Carte de circuits imprimés selon la revendication 11, **caractérisée en ce que** les premières et les deuxièmes faces de contact (18, 24) sont reliées les unes aux autres de façon électriquement conductrice.

13. Carte de circuits imprimés selon la revendication 12, **caractérisée en ce que** les premières et les deuxièmes faces de contact (18, 24) sont reliées les unes aux autres de façon électriquement conductrice au moyen de contacts traversants dans l'élément de support (1).

14. Carte de circuits imprimés selon la revendication 13, **caractérisée en ce que** les contacts traversants se composent d'ouvertures de passage (6) traversant l'élément de support (1), fermées de façon étanche au gaz et métallisées sur leurs parois ou entièrement remplies d'une masse de métal.

15. Carte de circuits imprimés selon la revendication 14, **caractérisée en ce que** la métallisation ou la masse de métal se compose du même matériau que les faces de contact (18, 24).

16. Carte de circuits imprimés selon l'une quelconque des revendications précédentes, **caractérisée en ce que** les régions de la couche d'argent (2, 5) ou de la couche contenant de l'argent non recouvertes par la couche de recouvrement (7, 8) sont recouvertes par une couche de protection.

17. Carte de circuits imprimés selon la revendication 16, **caractérisée en ce que** la couche de protection est une couche de verre (9, 10).

18. Carte de circuits imprimés selon l'une quelconque des revendications précédentes, **caractérisée en ce qu'**une ou plusieurs couche(s) de résistance (15) est/sont déposée(s) par la technique des couches épaisses sur l'élément de support (1) à proximité des faces de contact (18).

19. Carte de circuits imprimés selon la revendication 18, **caractérisée en ce que** les couches de résistance (15) sont recouvertes par la couche de protection.

20. Carte de circuits imprimés selon l'une quelconque des revendications précédentes, **caractérisée en ce qu'**un élément de curseur pouvant pivoter en fonction du niveau de remplissage du réservoir de véhicule est déplaçable sur les couches de recouvrement des faces de contact qui forment une voie de curseur.

21. Carte de circuits imprimés selon l'une quelconque des revendications 1 à 20, **caractérisée en ce qu'**un de plusieurs éléments de contact formant une voie de contact peut être déplacé en fonction du niveau de remplissage du réservoir de véhicule pour s'appliquer sur des couches de recouvrement (7) des faces de contact (18).

22. Carte de circuits imprimés selon une des revendications 20 et 21, **caractérisée en ce que** l'élément de curseur ou les éléments de contact se composent au moins en partie d'or.
